(19) Europäisches Patentamt
European Patent Office
Office européen des brevets

(11) **EP 3 524 990 B1**

(12) **FASCICULE DE BREVET EUROPEEN**

(45) Date de publication et mention de la délivrance du brevet:
**22.06.2022 Bulletin 2022/25**

(21) Numéro de dépôt: **19156325.3**

(22) Date de dépôt: **11.02.2019**

(51) Classification Internationale des Brevets (IPC):
**G01R 33/032** $^{(2006.01)}$ **G01R 33/26** $^{(2006.01)}$

(52) Classification Coopérative des Brevets (CPC):
**G01R 33/032; G01R 33/26**

(54) **MAGNÉTOMÈTRE VECTORIEL À POLARISATION LINÉAIRE ET CIRCULAIRE**

**VEKTOR-MAGNETOMETER MIT LINEARER UND ZIRKULÄRER POLARISATION**

**VECTOR MAGNETOMETER WITH LINEAR AND CIRCULAR POLARISATION**

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **12.02.2018 FR 1851170**

(43) Date de publication de la demande:
**14.08.2019 Bulletin 2019/33**

(73) Titulaire: **Commissariat à l'énergie atomique et aux énergies alternatives**
**75015 Paris (FR)**

(72) Inventeur: **PALACIOS LALOY, Agustin**
**38054 GRENOBLE CEDEX 09 (FR)**

(74) Mandataire: **Brevalex**
**95, rue d'Amsterdam**
**75378 Paris Cedex 8 (FR)**

(56) Documents cités:
**US-A- 5 254 947 US-A1- 2008 106 261**
**US-A1- 2010 156 419 US-A1- 2010 188 081**
**US-A1- 2016 116 553**

**Description**

## DOMAINE TECHNIQUE

Le domaine de l'invention est celui des magnétomètres à pompage optique et à résonance paramétrique asservis en champ nul.

## ÉTAT DE LA TECHNIQUE ANTÉRIEURE

Les magnétomètres à pompage optique utilisent des gaz atomiques confinés dans une cellule, typiquement de l'hélium métastable ou des gaz d'alcalins, en tant qu'élément sensible. Ces magnétomètres, qui peuvent prendre différentes configurations, permettent de remonter au champ magnétique en exploitant les trois processus suivants qui ont lieu de façon soit séquentielle soit concomitante :

1) L'utilisation de sources de lumière polarisée, typiquement des lasers, permet de préparer des états atomiques caractérisés par une certaine orientation ou alignement de leurs spins. Ce processus reçoit le nom de « pompage optique » dans le domaine.

2) Ces états atomiques évoluent sous l'effet du champ magnétique, notamment sous l'effet Zeeman, qui correspond à des décalages des niveaux d'énergie en fonction du champ magnétique auquel les atomes sont soumis.

3) Les propriétés optiques du milieu atomique subissent alors des modifications qui dépendent de l'état des atomes. On peut ainsi par une mesure optique, par exemple par une mesure d'absorption optique, remonter au décalage Zeeman subi, et en déduire une mesure du champ magnétique dans lequel est plongée la cellule.

Les documents US 5 254 947 A et US 2008/106261 A1 décrivent des exemples de magnétomètres à pompage optique.

Selon les différentes configurations possibles des magnétomètres à pompage optique existants, on distingue une mesure du module, aussi appelée norme, du champ magnétique pour les magnétomètres scalaires, ou une détermination des différentes composantes du champ magnétique pour les magnétomètres vectoriels, à l'emplacement de la cellule.

Le niveau de sensibilité, aussi appelé bas bruit, et de justesse atteignables avec de tels magnétomètres à pompage optique sont très remarquables et nettement plus favorables que ceux de la plupart des autres technologies de mesure magnétique (fluxgate, effet Hall, magnétorésistance, etc.). Seul le magnétomètre de type SQUID possède un bruit semblable, mais il requiert un refroidissement cryogénique de l'élément sensible, qui contient des éléments nécessitant d'être supraconducteurs pour son fonctionnement, ce qui restreint son champ d'application pratique.

Pour réaliser une mesure vectorielle du champ magnétique avec une bande passante large, il existe deux configurations bien connues : la première dite « à effet Hanle » et la deuxième qui reçoit le nom de « magnétomètre à résonance paramétrique ». Ces configurations sont décrites notamment dans l'article de J. Dupont-Roc, "Détermination par des méthodes optiques des trois composantes d'un champ magnétique très faible," Revue de Physique Appliquée, vol. 5, no. 6, pp. 853-864, 1970. Elles fonctionnent à des valeurs de champ magnétique extérieur très faibles, induisant un décalage Zeeman plus faible que le taux de relaxation des sous-niveaux Zeeman de l'atome, ce qui pour le cas de l'hélium fixe une limite autour de 100 à 150 nano Tesla, soit 500 fois moins intense que le champ magnétique terrestre.

Lorsqu'un faible champ magnétique statique transverse est appliqué à la cellule et balayé autour de zéro, les atomes sous soumis à un mouvement de précession et le nombre de photons absorbés, provenant du laser de pompage optique, subit des variations résonantes (effet Hanle). Des résonances analogues, appelées résonances paramétriques, en présence de champs magnétiques modulés en fréquence, sont observées lorsqu'un champ radiofréquence est appliqué. Dans ces conditions, le moment magnétique de chaque atome subit des oscillations résonantes aux fréquences multiples de celle du champ radiofréquence. La mesure de l'amplitude de ces oscillations permet de remonter au module de la composante du champ magnétique colinéaire au champ radiofréquence.

Dans ces deux configurations, il est avantageux de faire fonctionner le magnétomètre « en boucle fermée » en venant constamment soumettre l'élément sensible à un champ magnétique total nul. Ce fonctionnement dit avec asservissement en champ nul présente notamment l'avantage d'être moins sensible à la variation de paramètres expérimentaux (puissances laser, densité de l'élément sensible...).

Le champ magnétique total nul est obtenu en générant des champs magnétiques de compensation par injection de courants dans des bobines appropriées qui entourent l'élément sensible. Ces champs de compensation viennent annuler chacune des composantes du champ magnétique ambiant au moyen d'une régulation en boucle fermée des courants injectés. La mesure des courants circulant dans les bobines permet de déduire les champs qu'il est nécessaire d'appliquer pour annuler les différentes composantes du champ ambiant, et donc de disposer de la valeur de ces différentes composantes.

Le magnétomètre à résonance paramétrique permet ainsi de déduire les trois composantes du champ magnétique ambiant de manière indépendante ce qui rend possible la mesure vectorielle. Les deux composantes parallèles à l'axe d'application de deux champs radiofréquence sont ainsi obtenues en mesurant l'amplitude du signal de photo-détection démodulé à la fréquence d'oscillation du champ radiofréquence correspondant et en quadrature avec celle-ci. En effet, cette amplitude est directement proportionnelle au champ magnétique parallèle à l'axe du champ radiofréquence correspondant. Il est également possible d'obtenir la troisième composante du champ magnétique (perpendiculaire aux deux champs RF) car la première inter-harmonique des deux fréquences d'oscillation des champs radiofréquence est proportionnelle à son amplitude. Toutefois les facteurs de proportionnalité pour la mesure de ce troisième axe sont fortement défavorables par rapport aux deux premiers. Ainsi, le bruit dont est assortie la mesure du champ selon ce troisième axe est typiquement au moins un ordre de grandeur plus élevé que celui associés aux deux autres axes. Or ce niveau de bruit peut s'avérer problématique dans des applications du magnétomètre où la mesure de champ magnétique sert à déduire la position de sources de champ (courants ou matériaux magnétiques), cet excès de bruit induisant de fortes incertitudes sur les grandeurs de ces sources ou leur localisation.

## EXPOSÉ DE L'INVENTION

L'invention a pour objectif de pallier à cet excès de bruit affectant la mesure sur le troisième axe du magnétomètre pour permettre de réduire l'incertitude de la mesure vectorielle du champ magnétique. L'invention propose à cet effet un magnétomètre vectoriel à résonance paramétrique qui comprend :

-     une cellule destinée à être remplie d'un gaz atomique soumis à un champ magnétique ambiant,
-     une source de pompage optique agencée pour émettre en direction de la cellule un faisceau de pompe présentant une longueur d'onde de pompage,
-     un dispositif de détection de résonances paramétriques agencé pour recevoir un faisceau de sonde ayant traversé la cellule, le faisceau de sonde étant le faisceau de pompe ou un faisceau distinct du faisceau de pompe.

Le magnétomètre vectoriel comporte en outre un dispositif de polarisation configuré de manière à conférer une polarisation linéaire et une polarisation circulaire au faisceau de pompe émis en direction de la cellule et placer ainsi les atomes de gaz atomique dans un état à la fois aligné et orienté. Le dispositif de détection comprend un montage optique agencé de manière à séparer du faisceau de sonde ayant traversé la cellule des signaux optiques porteurs respectivement d'une information relative à un état d'alignement et à un état d'orientation des atomes du gaz atomique.

Certains aspects préférés mais non limitatifs de ce magnétomètre sont les suivants :

-     il comporte une source d'excitation de résonances paramétriques configurée de manière à ce qu'elle induise dans la cellule un champ radiofréquence d'excitation présentant trois composantes, chacune des composantes du champ radiofréquence oscillant à sa propre fréquence d'oscillation, et le dispositif de détection est configuré pour réaliser une détection synchrone à un harmonique de chacune des fréquences d'oscillation ;

-     le dispositif de détection est configuré pour mesurer l'amplitude du signal optique porteur de l'information relative à l'état d'orientation des atomes du gaz atomique à un harmonique de la fréquence d'oscillation de chacune des composantes du champ radiofréquence d'excitation orthogonales à la direction de propagation du faisceau de pompe, et pour mesurer l'amplitude du signal optique porteur de l'information relative à l'état d'alignement des atomes du gaz atomique à un harmonique de la fréquence d'oscillation de chacune des composantes du champ radiofréquence d'excitation orthogonales à la direction du champ électrique du faisceau de pompe ;

-     le montage optique comprend un diviseur du faisceau de sonde ayant traversé la cellule en une première voie et une deuxième voie, un analyseur d'état d'alignement sur la première voie et un analyseur d'état d'orientation circulaire sur la deuxième voie ;
-     l'analyseur d'état d'alignement comprend un polariseur linéaire et un photodétecteur ;
-     l'analyseur d'état d'orientation comprend un polariseur circulaire et un photodétecteur ;
-     l'analyseur d'état d'alignement comprend une lame quart d'onde, un séparateur de polarisation apte à séparer sur un premier et un deuxième chemin la polarisation circulaire droite et la polarisation circulaire gauche du faisceau de sonde et un photodétecteur sur chacun des premier et deuxième chemins ;
-     l'analyseur d'état d'orientation comprend un séparateur de polarisation apte à séparer sur un premier et un deuxième chemin la polarisation linéaire horizontale et la polarisation linéaire verticale du faisceau de sonde, et un photodétecteur sur chacun des premier et deuxième chemins ;
-     le montage optique comprend un séparateur temporel du faisceau de sonde ayant traversé la cellule alternativement en un faisceau polarisé circulairement et en un faisceau polarisé linéairement, et un analyseur d'état atomique en aval du séparateur ;
-     le dispositif de polarisation est configuré de manière à conférer simultanément la polarisation linéaire et la polarisation circulaire au faisceau de pompe émis en direction de la cellule ;
-     le dispositif de polarisation est configuré de manière à conférer alternativement la polarisation linéaire puis la polarisation circulaire au faisceau de pompe émis en direction de la cellule.

L'invention porte également sur un procédé de mesure d'un champ magnétique à l'aide d'un magnétomètre vectoriel à résonance paramétrique comprenant une cellule remplie d'un gaz atomique soumis à un champ magnétique ambiant, une source de pompage optique apte à émettre en direction de la cellule un faisceau de pompe accordé à une longueur d'onde de pompage, un dispositif de détection de résonances paramétriques recevant un faisceau de sonde ayant traversé la cellule et un système d'asservissement en boucle fermé du magnétomètre pour le faire fonctionner en champ nul. Ce procédé comprend les étapes consistant à polariser linéairement et circulairement le faisceau de pompe émis en direction de la cellule, et à séparer, au moyen d'un montage optique du dispositif de détection, des signaux optiques porteurs respectivement d'une information relative à un état d'alignement et à un état d'orientation des atomes du gaz atomique.

Certains aspects préférés mais non limitatifs de ce procédé sont les suivants :

- il comporte la génération dans la cellule, au moyen d'une source d'excitation de résonances paramétriques, un champ radiofréquence d'excitation présentant trois composantes, chacune des composantes du champ radiofréquence oscillant à sa propre fréquence d'oscillation, et une détection synchrone à un harmonique de chacune des fréquences d'oscillation ;
- il comporte une mesure de l'amplitude du signal optique porteur de l'information relative à l'état d'orientation des atomes du gaz atomique à un harmonique de la fréquence d'oscillation de chacune des composantes du champ radiofréquence d'excitation orthogonales à la direction de propagation du faisceau de lumière, et une mesure de l'amplitude du signal optique porteur de l'information relative à l'état d'alignement des atomes du gaz atomique à un harmonique de la fréquence d'oscillation de chacune des composantes du champ radiofréquence d'excitation orthogonales à la direction du champ électrique du faisceau de lumière ;
- il comprend une division du faisceau de lumière ayant traversé la cellule en une première voie et une deuxième voie, une analyse d'état d'alignement sur la première voie et une analyse d'état d'orientation sur la deuxième voie ;
- il comprend une séparation temporelle du faisceau de sonde ayant traversé la cellule alternativement en un faisceau polarisé circulairement et en un faisceau polarisé linéairement, et une analyse d'état atomique réalisée en aval de ladite séparation ;
- le faisceau de pompe émis en direction de la cellule est simultanément polarisé linéairement et circulairement ;
- le faisceau de pompe émis en direction de la cellule est alternativement polarisé linéairement puis circulairement.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

- la figure 1 est un schéma d'un magnétomètre conforme à l'invention ;
- la figure 2 est un schéma d'un exemple de disposition des champs radiofréquences par rapport aux composantes du pompage optique ;
- les figures 3, 4 et 5 sont des schémas de montages optiques pouvant être mis en œuvre dans le dispositif de détection de résonances paramétriques du magnétomètre selon l'invention.

## EXPOSÉ DÉTAILLÉ DE MODES DE RÉALISATION PARTICULIERS

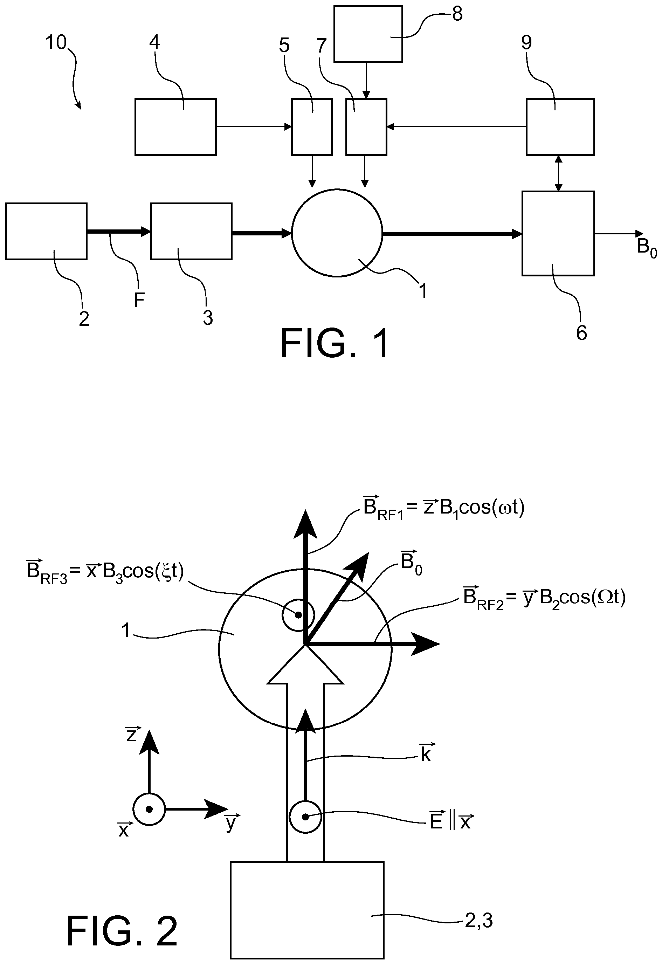

En référence à la figure 1, l'invention porte sur un magnétomètre vectoriel à pompage optique 10 qui comprend une cellule 1 remplie d'un gaz atomique, par exemple de l'hélium-4 ou un gaz alcalin, soumis à un champ magnétique ambiant $B_0$ dont la projection sur trois axes de coordonnées rectangulaires définit trois composantes. Le champ magnétique ambiant $B_0$ se décompose ainsi en trois composantes Bx, By et Bz chacune selon l'un des axes de mesure du magnétomètre x, y et z.

La cellule est éclairée par une source de pompage optique 2 apte à émettre en direction de la cellule 1 un faisceau de lumière F, par exemple un faisceau laser, accordé à une longueur d'onde de pompage (ce faisceau est ainsi également désigné par faisceau de pompe). La longueur d'onde de pompage est calée sur une raie de transition atomique, par exemple sur la raie $D_0$ à 1083 nm dans le cas de l'hélium-4. Le faisceau de lumière est polarisé au moyen d'un dispositif de polarisation 3 intercalé entre la source de pompage optique et la cellule ou directement intégré à la source de pompage optique.

Dans le cas où l'élément sensible est l'hélium-4, le magnétomètre 10 comporte par ailleurs un système de décharge haute fréquence (HF), comprenant un générateur HF 4 et des bobines de surtension 5, pour amener les atomes du gaz atomique dans un état énergisé où ils sont aptes à subir la transition atomique lorsqu'ils sont éclairés par le faisceau laser, typiquement dans l'état métastable $2^3S_1$.

Le magnétomètre comprend également un circuit d'excitation de résonances paramétriques qui comporte un générateur de radiofréquence 8 qui alimente des bobines d'Helmholtz 7 d'axes orthogonaux qui entourent la cellule afin de générer un champ magnétique d'excitation des résonances paramétriques, également désigné par champ radiofréquence d'excitation. Le magnétomètre comprend par ailleurs un dispositif de détection de résonances paramétriques 6 recevant un faisceau de lumière ayant traversé la cellule (i.e. un faisceau dit de sonde qui peut être le faisceau de pompe ou un faisceau distinct du faisceau de pompe).

Le magnétomètre peut également comprendre un système d'asservissement en boucle fermé du magnétomètre pour venir constamment soumettre l'élément sensible à un champ magnétique total nul. Le système d'asservissement comprend un régulateur 9 couplé au dispositif de détection 6 et qui injecte un courant dans les bobines de Helmholtz 7 afin de générer un champ magnétique de compensation Bc tel que la somme Bc+Bo est maintenue à zéro en permanence.

Alternativement, le magnétomètre peut être opéré en boucle ouverte, sans compensation du champ ambiant.

Il est usuel de réaliser le pompage avec une lumière polarisée circulairement, ce qui induit des états atomiques dits « orientés » qui se caractérisent par le fait que la valeur moyenne de leur moment magnétique de spin est différente de zéro dans la direction correspondant à la propagation du faisceau de pompe. Par exemple si cette direction correspond à l'axe z, le moment magnétique de spin Sz aura une valeur moyenne non nulle.

On peut également réaliser un pompage avec une lumière polarisée linéairement, ce qui induit des états atomiques dits « alignés » qui se caractérisent par le fait que la valeur moyenne d'une observable de deuxième ordre sur le moment magnétique de spin est différente de zéro. Par exemple un état aligné selon l'axe z se caractérise par le fait que l'observable $3S_z^2 - \vec{S}^2$ est différente de zéro. L'axe d'alignement est alors fixé par la direction du champ électrique de la lumière utilisée pour le pompage, une lumière avec un champ électrique parallèle à z créant un alignement selon z.

L'invention propose de réaliser différemment le pompage en adoptant pour dispositif de polarisation 3 un dispositif configuré pour conférer une polarisation linéaire et une polarisation circulaire au faisceau de pompe émis en direction de la cellule. Notamment, ce dispositif est configuré pour conférer aux atomes de gaz atomique dans la cellule un état à la fois aligné et orienté.

Le dispositif de polarisation 3 peut être configuré pour conférer simultanément la polarisation linéaire et la polarisation circulaire, le faisceau de pompe émis en direction de la cellule étant dès lors polarisé elliptiquement. Un tel dispositif 3 peut comprendre un polariseur linéaire et une lame quart d'onde dont les axes neutres sont tournés à un angle différent de 45° par rapport à ceux du polariseur linéaire, par exemple de 22,5°.

Une telle polarisation elliptique a pour effet de préparer les états atomiques selon une orientation et un alignement résultant à la fois d'une polarisation linéaire et d'une polarisation circulaire. Ainsi, l'état que les atomes de gaz atomique dans la cellule acquièrent, est à la fois aligné et orienté, en proportion au degré d'ellipticité de la polarisation. L'état des atomes se décompose plus particulièrement en une orientation le long de la propagation du faisceau de pompe et un alignement principalement orienté le long de l'axe de la polarisation linéaire du faisceau de pompe (avec une faible composante longitudinale à la propagation de la lumière résultant d'un terme résiduel provenant du pompage en polarisation circulaire).

Alternativement, le dispositif de polarisation 3 peut être configuré pour conférer alternativement la polarisation linéaire puis la polarisation circulaire. Un tel polariseur 3 peut comprendre un polariseur linéaire et une lame de retard contrôlable électriquement. Cette lame est modulée avec une onde carrée de manière à ce que pendant les demi-périodes où son niveau de sortie est haut (noté SH), elle se comporte comme une lame quart d'onde, alors que pendant les demi-périodes de niveau bas (noté SL) elle se comporte comme une lame sans retard ou comme une lame demi-onde. Ainsi, pendant les demi-périodes SH, le faisceau de pompe émis en direction de la cellule est polarisé circulairement et les états atomiques dans la cellule sont orientés. Et pendant les demi-périodes SH, le faisceau de pompe émis en direction de la cellule est polarisé linéairement et les états atomiques dans la cellule sont orientés. La dynamique des atomes étant dominée par un temps de relaxation de l'ordre de 1 ms, si la modulation SL/SH est plus rapide (ce qui est le cas dans l'exemple présenté ci-après), les atomes sont placés dans une superposition des états alignés et orientés. Il ne s'agit donc pas d'un passage successif par ces deux états mais de la concomitance des deux propriétés.

On notera qu'afin de limiter l'impact d'effets magnéto-optiques non-linéaires, on limite de préférence la puissance lumineuse du faisceau de pompe de sorte qu'elle soit typiquement inférieure ou de l'ordre de l'intensité de saturation. Ces effets, décrits par exemple dans l'article de D. Budker et al. "Résonant nonlinear magneto-optical effects in atoms," Rev. Mod. Phys., vol. 74, no. 4, pp. 1153-1201, Nov. 2002, peuvent en effet induire des couplages entre les évolutions des composantes en orientation et en alignement qui rendent notablement plus complexe l'évolution de l'état des atomes et nuisent au bon fonctionnement de l'invention.

Dans le cadre de l'invention, on prévoit une paire de bobines 7 sur chacun des axes du magnétomètre de manière à générer un champ radiofréquence d'excitation présentant trois composantes orthogonales. La source d'excitation de résonances paramétriques est plus particulièrement pilotée de manière à ce qu'elle induise dans la cellule un champ radiofréquence d'excitation présentant trois composantes, chacune de ces composantes oscillant à sa propre fréquence d'oscillation. On retrouve ainsi une composante RFx, une composante RFy et une composante RFz sur les axes x, y et z de pulsations respectives $\xi$, $\Omega$ et $\omega$.

Dans ces conditions, le moment magnétique de chaque atome dans la cellule subit des oscillations résonantes aux fréquences multiples de celle des composantes du champ radiofréquence d'excitation. Il en résulte alors une modulation de la lumière transmise, notamment aux pulsations $\xi$, $\Omega$ et $\omega$. L'amplitude des oscillations à l'une de ces pulsations permet ainsi de mesurer le module du champ magnétique colinéaire à la composante correspondante du champ RF.

On a représenté sur la figure 2 un exemple de disposition des composantes du champ radiofréquence par rapport aux composantes du pompage. Sur cette figure, $\vec{k}$ désigne le vecteur de propagation du faisceau de pompe orienté selon la direction $\vec{z}$ et $\vec{E}$ désigne le champ électrique, orienté selon la direction $\vec{x}$, correspondant à la direction linéaire de la polarisation elliptique. Les bobines 7 permettent de générer une composante du champ radiofréquence d'excitation par axe du magnétomètre, à savoir une composante $\overrightarrow{B_{RF1}}$ orientée selon l'axe $\vec{z}$, une composante $\overrightarrow{B_{RF2}}$ orientée selon l'axe $\vec{y}$ et une composante $\overrightarrow{B_{RF3}}$ orientée selon l'axe $\vec{x}$, de pulsations respectives $\omega$, $\Omega$ et $\xi$.

Dans un exemple de réalisation, la composante $\overrightarrow{B_{RF2}}$ orthogonale aux deux directions préférentielles de pompage présente la fréquence la plus élevée, par exemple 50 kHz. Les deux autres composantes du champ radiofréquence présentent des fréquences nettement plus faibles, bien que nettement supérieures au taux de relaxation des atomes, et dans un rapport non entier entre elles et par rapport à la fréquence de la composante $\overrightarrow{B_{RF2}}$. Par exemple, pour l'hélium où le taux de relaxation des atomes est de l'ordre de 1 kHz, les fréquences des composantes $\overrightarrow{B_{RF1}}$ et $\overrightarrow{B_{RF3}}$ peuvent être fixées à 7 kHz et 9 kHz respectivement.

Les composantes $\overrightarrow{B_{RF2}}$ et $\overrightarrow{B_{RF3}}$ sont strictement orthogonales à la direction de l'orientation. L'orientation atomique subit donc une évolution dépendante de ces composantes, alors que la composante $\overrightarrow{B_{RF1}}$ qui est parallèle à la direction de pompage n'a qu'un effet au deuxième ordre sur l'évolution de cette orientation. L'évolution de l'orientation atomique se réduit donc pour l'essentiel à celle qu'il y aurait en l'absence de $\overrightarrow{B_{RF1}}$. Ainsi, l'orientation présente des composantes aux fréquences (ainsi que leurs harmoniques et inter-harmoniques) des composantes $\overrightarrow{B_{RF2}}$ et $\overrightarrow{B_{RF3}}$ de pulsation respective $\Omega$ et $\xi$. L'amplitude d'un signal de photo-détection démodulé à l'une de ces fréquences est proportionnelle à la composante du champ magnétique ambiant parallèle à la composante correspondante du champ radiofréquence. On peut ainsi remonter notamment aux composantes By et Bx du champ ambiant. Et la première inter-harmonique à $\Omega \pm \xi$ permet de remonter à la composante Bz du champ ambiant avec toutefois un niveau de bruit significativement plus élevé. Mais ce niveau de bruit est compensé par la mesure de Bz décrite ci-après via l'alignement conféré aux atomes.

Les composantes $\overrightarrow{B_{RF1}}$ et $\overrightarrow{B_{RF2}}$ sont orthogonales à la direction du champ électrique $\vec{E}$. L'évolution

de l'alignement atomique est donc principalement contrôlée par ces deux composantes, alors que la composante $\overrightarrow{B_{RF3}}$ parallèle à cet alignement a un faible impact sur celui-ci. Cet impact est néanmoins un peu plus important que celui que la composante $\overrightarrow{B_{RF1}}$ a sur l'orientation du fait d'un résidu d'alignement longitudinal provenant de l'alignement induit par la polarisation circulaire (alors qu'il n'y a pas de composantes orientées par un quelconque résidu induit par la polarisation linéaire). L'évolution de l'alignement est néanmoins sensiblement semblable à celle qu'il y aurait en l'absence de $\overrightarrow{B_{RF3}}$, de façon similaire à ce qui est observé dans les magnétomètres à pompage optique pompés en alignement comme décrit par exemple dans S. Morales et al., "Magnetocardiography measurements with 4He vector optically pumped magnetometers at room temperature," Phys. Med. Biol., 2017. Ainsi l'alignement présente des composantes aux fréquences (ainsi que leurs harmoniques et inter-harmoniques) des composantes $\overrightarrow{B_{RF1}}$ et $\overrightarrow{B_{RF2}}$ de pulsation respective $\omega$ et $\Omega$. L'amplitude d'un signal de photo-détection à l'une de ces fréquences est proportionnelle à la composante du champ magnétique ambiant parallèle à la composante correspondante du champ RF. On peut ainsi notamment remonter aux composantes Bz et By du champ ambiant. Et la première inter-harmonique à $\omega \pm \Omega$ permet de remonter à la composante Bx du champ ambiant avec un niveau de bruit nettement moins favorable que pour les deux autres composantes. Mais ce niveau de bruit est compensé par la mesure de Bx précédemment décrite via l'orientation conférée aux atomes.

Le dispositif de détection de résonances paramétriques 6 est ainsi configuré pour suivre l'évolution des alignements et orientations atomiques et obtenir par démodulation synchrone aux trois fréquences des composantes du champ radiofréquence les amplitudes des trois composantes du champ magnétique ambiant. Le dispositif de détection 6 comprend à cet effet un montage optique configuré pour séparer, temporellement ou spatialement, des signaux optiques porteurs respectivement d'une information relative à un état d'alignement et à un état d'orientation des atomes du gaz atomique.

Le dispositif de détection peut notamment être configuré pour mesurer l'amplitude du signal optique porteur de l'information relative à l'état d'orientation des atomes du gaz atomique à un harmonique de chacune des composantes du champ radiofréquence d'excitation orthogonales à la direction de propagation $\vec{k}$ du faisceau laser, à savoir les composantes $\overrightarrow{B_{RF2}}$ et $\overrightarrow{B_{RF3}}$, cette amplitude étant respectivement proportionnelle à la composante By et Bx du champ ambiant.

Le dispositif de détection est en outre configuré pour mesurer l'amplitude du signal optique porteur de l'information relative à l'état d'alignement des atomes du gaz atomique à un harmonique de chacune des composantes du champ radiofréquence d'excitation, orthogonales à la direction du champ électrique $\vec{E}$, à savoir les

composantes $\overrightarrow{B_{RP1}}$ et $\overrightarrow{B_{RF2}}$, cette amplitude étant respectivement proportionnelle à la composante Bz et By du champ ambiant.

Comme décrit par la suite, l'analyse du signal optique porteur d'une information relative à un état d'alignement, respectivement à un état d'orientation des atomes du gaz atomique, peut être une analyse relative à l'absorption de la composante linéaire, respectivement circulaire, lors de la traversée de la cellule, ou peut être une analyse relative à la proportion relative des polarisations circulaires droite et gauche, respectivement des polarisations linéaires horizontale et verticale, dans le faisceau ayant traversé la cellule.

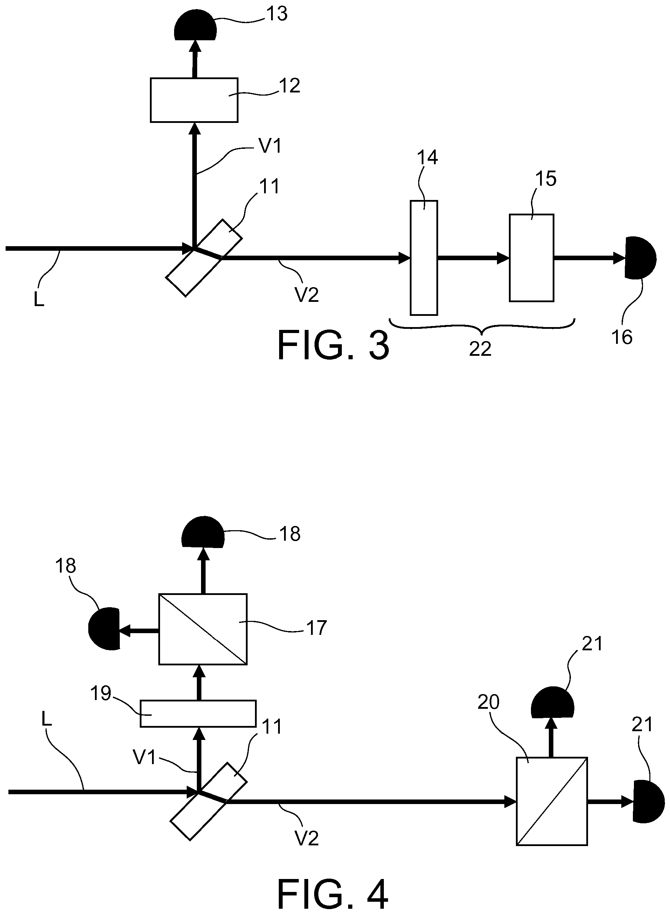

Dans un premier mode de réalisation illustré sur les figures 3 et 4, le montage optique comprend un diviseur 11 du faisceau de sonde L ayant traversé la cellule en une première voie V1 et une deuxième voie V2, un analyseur d'état d'alignement sur la première voie et un analyseur d'état d'orientation sur la deuxième voie. Il n'est en effet pas possible de positionner en série de tels analyseurs, car l'information sur la polarisation circulaire/linéaire est totalement perdue à la sortie d'un tel analyseur. On procède donc à une séparation spatiale de la lumière en deux parties à l'aide du diviseur 11, ces deux parties présentant une énergie égale ou semblable, ce qui permet notamment de pouvoir mesurer de façon concomitante l'alignement et l'orientation. Selon un exemple de réalisation particulier, le diviseur 11 est une lame séparatrice non polarisante qui sépare la puissance du faisceau sur les deux voies V1, V2, chacune présentant 50% de la puissance incidente du faisceau lumineux L.

Lorsque le faisceau lumineux utilisé pour le pompage est également utilisé en tant que faisceau de sonde pour la détection, l'information sur l'alignement et l'orientation est contenue dans l'absorption des composantes respectivement linéaires et circulaires. Comme représenté sur la figure 3, l'analyseur d'état d'alignement sur l'une des voies comprend un polariseur linéaire 12 et un photodétecteur 13 qui fournit un signal de photo-détection porteur d'une information relative à l'état d'alignement des atomes, et l'analyseur d'état d'orientation sur l'autre des voies comprend un polariseur circulaire 22 (une lame quart d'onde 14 associée à un polariseur linéaire 15) et un photodétecteur 16 qui fournit un signal de photo-détection porteur d'une information relative à l'état d'orientation des atomes.

Il est avantageux pour gagner en sensibilité d'utiliser un faisceau de sonde distinct du faisceau de pompe. Dans un tel cas de figure, il est utile de décaler la fréquence de la lumière de sonde par rapport à la fréquence de la transition atomique utilisée de manière à ne pas induire de pompage résiduel avec le faisceau de sonde. Ce décalage fait qu'une mesure en absorption est peu efficace. Il est donc préférable de réaliser une mesure en biréfringence consistant à mesurer la proportion relative des polarisations circulaires gauche et droite ou des polarisations linéaire horizontale et verticale.

Pour ce faire, comme représenté sur la figure 4, l'analyseur d'état d'alignement sur la première voie V1 comprend une lame quart d'onde 19, un séparateur de polarisation 17 apte à séparer sur un premier et un deuxième chemin la polarisation circulaire droite et la polarisation circulaire gauche du faisceau laser, et un photodétecteur 18 sur chacun des premier et deuxième chemins pour permettre de mesurer le rapport d'intensité lumineuse entre les deux polarisations circulaires et fournir ainsi un signal de photo-détection porteur d'une information relative à l'alignement des atomes. Et l'analyseur d'état d'orientation sur la deuxième voie V2 comprend un séparateur de polarisation 20 apte à séparer sur un premier et un deuxième chemin la polarisation linéaire horizontale et la polarisation linéaire verticale du faisceau laser, et un photodétecteur 21 sur chacun des premier et deuxième chemins pour permettre de mesurer le rapport d'intensité lumineuse entre les deux polarisations linéaires et fournir ainsi un signal de photo-détection porteur d'une information relative à l'orientation des atomes.

Dans un second mode de réalisation utilisable que le faisceau de sonde soit distinct ou non du faisceau de pompe (lorsque le faisceau de sonde est identique au faisceau de sonde, la polarisation est du type alternance d'une polarisation linéaire et d'une polarisation circulaire), on procède à une séparation temporelle sur une même voie des signaux optiques porteurs des informations d'alignement et d'orientation. Cette séparation temporelle est réalisée à une fréquence plus rapide que le temps de relaxation des atomes et non commensurable aux fréquences des composantes du champ RF, par exemple à une fréquence de de 1MHz.

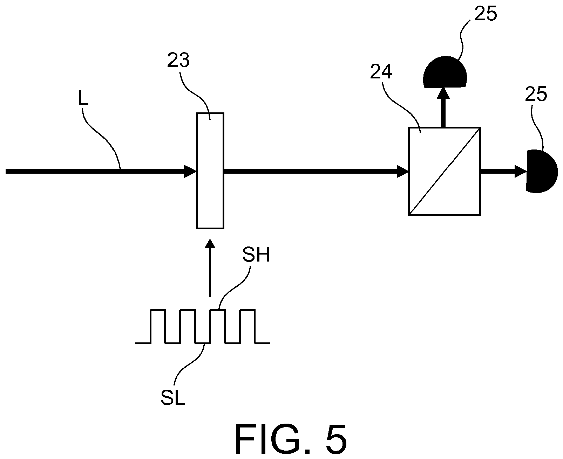

Comme représenté en figure 5, le montage optique peut comprendre à cet effet une lame de retard contrôlable électriquement 23. Cette lame est modulée avec une onde carrée de manière à ce que pendant les demi-périodes où son niveau de sortie est haut (noté SH), elle se comporte comme une lame quart d'onde, alors que pendant les demi-périodes de niveau bas (noté SL) elle se comporte comme une lame sans retard ou comme une lame demi-onde. A la suite de cette lame, le montage optique comprend un analyseur d'état atomique réalisant une mesure en absorption ou une mesure en biréfringence avec un séparateur de polarisation 24 et deux photodétecteurs 24. Prenant l'exemple d'une mesure en biréfringence, pendant les phases SL, la sortie de l'analyseur d'état atomique est proportionnelle à la différence entre les deux polarisations linéaires, qui correspond à une rotation du plan de polarisation de la sonde et permet de mesurer l'orientation selon l'axe de propagation de celle-ci, selon un schéma de mesure connu dans le domaine sous le nom de « schéma Faraday », comme expliqué par exemple dans l'article F. Laloë, M. Leduc, and P. Minguzzi, "Relations entre l'état angulaire d'une vapeur atomique soumise au pompage optique et ses propriétés d'absorption et de dispersion.," Journal de Physique, vol. 30, no. 2-3, pp. 277-288, 1969. Pendant les phases SH, la sortie de l'analyseur d'état atomique est proportionnelle à la différence d'intensité entre les deux polarisations circulaires, ce qui permet d'obtenir de l'information sur l'alignement atomique transverse à la direction de propagation du faisceau de sonde selon ce qui est rapporté dans ce même article.

L'invention n'est pas limitée au magnétomètre vectoriel précédemment décrit, et s'étend également à un procédé de mesure d'un champ magnétique à l'aide d'un tel magnétomètre, et notamment à un procédé comprenant les étapes consistant à polariser linéairement et circulairement le faisceau de lumière émis en direction de la cellule, et à séparer, au moyen d'un montage optique du dispositif de détection, des signaux optiques porteurs respectivement d'une information relative à un état d'alignement et à un état d'orientation des atomes du gaz atomique.

## Revendications

1. Magnétomètre vectoriel à pompage optique (10) comprenant :

   - une cellule (1) destinée à être remplie d'un gaz atomique soumis à un champ magnétique ambiant (Bo),
   - une source de pompage optique (2) agencée pour émettre en direction de la cellule (1) un faisceau de pompe (F) présentant une longueur d'onde de pompage,
   - un dispositif de détection de résonances paramétriques (6) agencé pour recevoir un faisceau de sonde (L) ayant traversé la cellule, le faisceau de sonde étant le faisceau de pompe ou un faisceau distinct du faisceau de pompe,

   **caractérisé en ce qu'**il comporte en outre un dispositif de polarisation (3) configuré de manière à conférer une polarisation linéaire et une polarisation circulaire au faisceau de pompe émis en direction de la cellule (1) et placer ainsi les atomes du gaz atomique dans un état à la fois aligné et orienté, et **en ce que** le dispositif de détection (6) comprend un montage optique agencé de manière à séparer du faisceau de sonde ayant traversé la cellule des signaux optiques porteurs respectivement d'une information relative à un état d'alignement et à un état d'orientation des atomes du gaz atomique, ladite information permettant de mesurer le champ magnétique ambiant (Bo).

2. Magnétomètre vectoriel selon la revendication 1, comprenant une source d'excitation de résonances paramétriques (7, 8) configurée de manière à ce qu'elle induise dans la cellule un champ radiofréquence d'excitation ($\overrightarrow{B_{RF1}}$, $\overrightarrow{B_{RF2}}$, $\overrightarrow{B_{RF3}}$) présentant trois composantes oscillant chacune à sa propre fréquence d'oscillation, et dans lequel le dispositif de détection (6) est configuré pour réaliser une détection synchrone à un harmonique de chacune des fréquences d'oscillation.

3. Magnétomètre vectoriel selon la revendication 2, dans lequel le dispositif de détection (6) est configuré pour mesurer l'amplitude du signal optique porteur de l'information relative à l'état d'orientation des atomes du gaz atomique à un harmonique de la fréquence d'oscillation de chacune des composantes du champ radiofréquence d'excitation ($\overrightarrow{B_{RF2}}$, $\overrightarrow{B_{RF3}}$) orthogonales à la direction de propagation ($\vec{k}$) du faisceau de pompe, et pour mesurer l'amplitude du signal optique porteur de l'information relative à l'état d'alignement des atomes du gaz atomique à un harmonique de la fréquence d'oscillation de chacune des composantes du champ radiofréquence d'excitation ($\overrightarrow{B_{RF1}}$, $\overrightarrow{B_{RF2}}$) orthogonales à la direction du champ électrique ($\vec{E}$) du faisceau de pompe.

4. Magnétomètre vectoriel selon l'une des revendications 1 à 3, dans lequel le montage optique comprend un diviseur (11) du faisceau de sonde (L) ayant traversé la cellule en une première voie (V1) et une deuxième voie (V2, un analyseur d'état d'alignement sur la première voie (V1) et un analyseur d'état d'orientation sur la deuxième voie (V2).

5. Magnétomètre vectoriel selon la revendication 4, dans lequel l'analyseur d'état d'alignement comprend un polariseur linéaire (12) et un photodétecteur (13).

6. Magnétomètre vectoriel selon l'une des revendications 4 et 5, dans lequel l'analyseur d'état d'orientation circulaire comprend un polariseur circulaire (14, 15) et un photodétecteur (16).

7. Magnétomètre vectoriel selon la revendication 4, dans lequel l'analyseur d'état d'alignement comprend une lame quart d'onde (19), un séparateur de polarisation (17) apte à séparer sur un premier et un deuxième chemin la polarisation circulaire droite et la polarisation circulaire gauche du faisceau de sonde et un photodétecteur (18) sur chacun des premier et deuxième chemins.

8. Magnétomètre vectoriel selon l'une des revendications 4 et 7, dans lequel l'analyseur d'état d'orientation comprend un séparateur de polarisation (20) apte à séparer sur un premier et un deuxième chemin la polarisation linéaire horizontale et la polarisation linéaire verticale du faisceau de sonde, et un photodétecteur (21) sur chacun des premier et deuxième chemins.

9. Magnétomètre vectoriel selon l'une des revendications 1 à 3, dans lequel le montage optique comprend un séparateur temporel du faisceau de sonde ayant traversé la cellule alternativement en un faisceau polarisé circulairement et en un faisceau polarisé linéairement, et un analyseur d'état atomique (24, 25) en aval du séparateur.

10. Magnétomètre vectoriel selon l'une des revendications 1 à 9, dans lequel le dispositif de polarisation (3) est configuré de manière à conférer simultanément la polarisation linéaire et la polarisation circulaire au faisceau de pompe émis en direction de la cellule.

11. Magnétomètre vectoriel selon l'une des revendications 1 à 9, dans lequel le dispositif de polarisation (3) est configuré de manière à conférer alternativement la polarisation linéaire puis la polarisation circulaire au faisceau de pompe émis en direction de la cellule.

12. Procédé de mesure d'un champ magnétique à l'aide d'un magnétomètre vectoriel (10) comprenant une cellule (1) remplie d'un gaz atomique soumis à un champ magnétique ambiant, une source de pompage optique (2) apte à émettre en direction de la cellule un faisceau de pompe accordé à une longueur d'onde de pompage, un dispositif de détection de résonances paramétriques (6) recevant un faisceau de sonde (L) ayant traversé la cellule, le faisceau de sonde étant le faisceau de pompe ou un faisceau distinct du faisceau de pompe, et un système d'asservissement (7, 8, 9) en boucle fermé du magnétomètre pour le faire fonctionner en champ nul, **caractérisé en ce qu'**il comprend les étapes consistant à polariser linéairement et circulairement le faisceau de pompe émis en direction de la cellule de manière à placer les atomes du gaz atomique dans un état à la fois aligné et orienté, et à séparer, du faisceau de sonde ayant traversé la cellule au moyen d'un montage optique du dispositif de détection, des signaux optiques porteurs respectivement d'une information relative à un état d'alignement et à un état d'orientation des atomes du gaz atomique.

**Patentansprüche**

1. Vektor-Magnetometer mit optischem Pumpen (10), umfassend:

   - eine Zelle (1), vorgesehen, um mit einem atomaren Gas gefüllt zu werden, das einem Umgebungsmagnetfeld ($B_0$) ausgesetzt ist,
   - eine Quelle des optischen Pumpens (2), eingerichtet, um in Richtung der Zelle (1) einen Pumpenstrahl (F), der eine Pumpwellenlänge aufweist, zu emittieren,
   - eine Vorrichtung zur Erfassung parametrischer Resonanzen (6), eingerichtet, um einen Sondenstrahl (L) zu empfangen, der die Zelle durchdrungen hat, wobei der Sondenstrahl der Pumpenstrahl ist oder ein gesonderter Strahl des Pumpenstrahls,

   **dadurch gekennzeichnet, dass** es ferner eine Polarisationsvorrichtung (3) enthält, die so konfiguriert ist, dass sie dem in Richtung der Zelle (1) emittierten Pumpenstrahl eine lineare Polarisation und eine zirkulare Polarisation verleiht und dadurch die Atome des atomaren Gases in einen sowohl ausgerichteten als auch orientierten Zustand versetzt, und dass die Erfassungsvorrichtung (6) eine optische Anordnung umfasst, die so eingerichtet ist, dass sie vom Sondenstrahl, der die Zelle durchdrungen hat, optische Signale abtrennt, die jeweils eine Information bezüglich eines Ausrichtungszustands und eines Orientierungszustands der Atome des atomaren Gases tragen, wobei die Information die Messung des Umgebungsmagnetfeldes ($B_0$) ermöglicht.

2. Vektor-Magnetometer nach Anspruch 1, eine Erregungsquelle von parametrischen Resonanzen (7, 8) umfassend, so konfiguriert, dass sie in der Zelle ein Erregungsfunkfrequenzfeld ($\vec{B_{RF1}}$, $\vec{B_{RF2}}$, $\vec{B_{RF3}}$) induziert, das drei Komponenten aufweist, die jede in ihrer eigenen Schwingungsfrequenz schwingt, und wobei die Erfassungsvorrichtung (6) konfiguriert ist, um eine synchrone Erfassung einer Harmonischen jeder der Schwingungsfrequenzen durchzuführen.

3. Vektor-Magnetometer nach Anspruch 2, wobei die Erfassungsvorrichtung (6) konfiguriert ist, um die Amplitude des optischen Signals zu messen, das die Information trägt bezüglich des Orientierungszustands der Atome des atomaren Gases einer Harmonischen der Schwingungsfrequenz jeder der Komponenten des Erregungsfunkfrequenzfeldes ($\vec{B_{RF2}}$, $\vec{B_{RF3}}$) orthogonal zur Ausbreitungsrichtung ($\vec{k}$) des Pumpenstrahls, und um die Amplitude des optischen Signals zu messen, das die Information trägt bezüglich des Ausrichtungszustands der Atome des atomaren Gases einer Harmonischen der Schwingungsfrequenz jeder der Komponenten des Erregungsfunkfrequenzfeldes ($\vec{B_{RF1}}$, $\vec{B_{RF2}}$) orthogonal zur Richtung des elektrischen Feldes ($\vec{E}$) des Pumpenstrahls.

4. Vektor-Magnetometer nach einem der Ansprüche 1 bis 3, wobei die optische Anordnung einen Teiler (11) des Sondenstrahls (L) umfasst, der die Zelle auf einem ersten Pfad (V1) und einem zweiten Pfad (V2) durchdrungen hat, einen Ausrichtungszustand-Analysator auf dem ersten Pfad (V1) und einen Orientierungszustand-Analysator auf dem zweiten Pfad (V2).

5.  Vektor-Magnetometer nach Anspruch 4, wobei der Ausrichtungszustand-Analysator einen linearen Polarisator (12) und einen Photodetektor (13) umfasst.

6.  Vektor-Magnetometer nach einem der Ansprüche 4 und 5, wobei der zirkulare Orientierungszustand-Analysator einen zirkularen Polarisator (14, 15) und einen Photodetektor (16) umfasst.

7.  Vektor-Magnetometer nach Anspruch 4, wobei der Ausrichtungszustand-Analysator eine Viertelwellenplatte (19) umfasst, einen Polarisationstrenner (17), geeignet, um die rechte zirkulare Polarisation und die linke zirkulare Polarisation des Sondenstrahls auf einen ersten auf einen zweiten Weg abzutrennen und einen Photodetektor (18) auf dem ersten und auf dem zweiten Weg.

8.  Vektor-Magnetometer nach einem der Ansprüche 4 und 7, wobei der Orientierungszustand-Analysator einen Polarisationstrenner (20) umfasst, geeignet, um die horizontale lineare Polarisation und die vertikale lineare Polarisation des Sondenstrahls auf einen ersten und auf einen zweiten Weg abzutrennen und einen Photodetektor (21) auf dem ersten und auf dem zweiten Weg.

9.  Vektor-Magnetometer nach einem der Ansprüche 1 bis 3, wobei die optische Anordnung einen zeitlichen Trenner des Sondenstrahls umfasst, der die Zelle abwechselnd in einem zirkular polarisierten Strahl und einem linear polarisierten Strahl durchdrungen hat, und einen atomaren Zustandsanalysator (24, 25), dem Trenner nachgeschaltet.

10.  Vektor-Magnetometer nach einem der Ansprüche 1 bis 9, wobei die Polarisationsvorrichtung (3) so konfiguriert ist, dass sie dem in Richtung der Zelle emittierten Pumpenstrahl gleichzeitig die lineare Polarisation und die zirkulare Polarisation verleiht.

11.  Vektor-Magnetometer nach einem der Ansprüche 1 bis 9, wobei die Polarisationsvorrichtung (3) so konfiguriert ist, dass sie dem in Richtung der Zelle emittierten Pumpenstrahl abwechselnd die lineare Polarisation und dann die zirkulare Polarisation verleiht.

12.  Verfahren zur Messung eines Magnetfeldes mithilfe eines Vektor-Magnetometers (10), eine Zelle (1) umfassend, die mit einem atomaren Gas gefüllt ist, das einem Umgebungsmagnetfeld ausgesetzt ist, eine Quelle des optischen Pumpens (2), die geeignet ist, einen Pumpenstrahl, der auf eine Pumpwellenlänge abgeglichen ist, in Richtung der Zelle zu emittieren, eine Erfassungsvorrichtung von parametrischen Resonanzen (6), die einen Sondenstrahl (L) empfängt, der die Zelle durchdrungen hat, wobei der Sondenstrahl der Pumpenstrahl ist oder ein Strahl, der gesondert ist vom Pumpenstrahl, und ein Regelungssystem (7, 8, 9) mit geschlossener Schleife des Magnetometers, um es im Nullfeld zu betreiben, **dadurch gekennzeichnet, dass** es die Schritte umfasst, die darauf beruhen, den in Richtung der Zelle emittierten Pumpenstrahl linear- und zirkular so zu polarisieren, dass die Atome des atomaren Gases in einen sowohl ausgerichteten als auch orientierten Zustand versetzt werden, und optische Signale, die jeweils eine Information bezüglich eines Ausrichtungszustands und eines Orientierungszustands der Atome des atomaren Gases tragen, vom Sondenstrahl abzutrennen, der die Zelle mittels einer optische Anordnung der Erfassungsvorrichtung durchdrungen hat.

**Claims**

1.  Optically pumped vector magnetometer (10) comprising:

    -  a cell (1) that will be filled by an atomic gas subjected to an ambient magnetic field (Bo),
    -  an optical pumping source (2) arranged to emit a pump beam (F) with a pumping wavelength towards the cell (1),
    -  a parametric resonance detection device (6) arranged to receive a probe beam (L) that has passed through the cell, the probe beam being the pump beam or a beam distinct from the pump beam,

    **characterised in that** it also comprises a polarisation device (3) configured so as to confer a linear polarisation and a circular polarisation onto the pump beam emitted towards the cell (1) and thus to place atoms of the atomic gas in an aligned and oriented state, and **in that** the detection device (6) comprises an optical set up arranged to separate optical signals carrying information about an alignment state from information about an orientation state of the atoms of the atomic gas respectively , in the probe beam that has passed through the cell, said information being used to measure the ambient magnetic field ($B_0$).

2.  Vector magnetometer according to claim 1, comprising a parametric resonance excitation source (7, 8) configured such that it induces a radio frequency excitation field ($\overrightarrow{B_{RF1}}$, $\overrightarrow{B_{RF2}}$, $\overrightarrow{B_{RF3}}$) with three components in the cell each oscillating at its own oscillation frequency, and wherein the detection device (6) is configured to make detection synchronous with a harmonic of each oscillation frequency.

3. Vector magnetometer according to claim 2, wherein the detection device (6) is configured to measure the amplitude of the optical signal carrying information about the orientation state of atoms of the atomic gas at a harmonic of the oscillation frequency of each of the components of the radio frequency excitation field $(\overrightarrow{B_{RF2}}, \overrightarrow{B_{RF3}})$ orthogonal to the propagation direction $(\vec{k})$ of the pump beam, and to measure the amplitude of the optical signal carrying information about the alignment state of atoms of the atomic gas at a harmonic of the oscillation frequency of each of the components of the radio frequency excitation field $(\overrightarrow{B_{RF1}}, \overrightarrow{B_{RF2}})$ orthogonal to the direction of the electric field $(\vec{E})$ of the pump beam.

4. Vector magnetometer according to any one of claims 1 to 3, wherein the optical set up comprises a divider (11) of the probe beam (L) that passed through the cell into a first channel (V1) and a second channel (V2), an alignment state analyser on the first channel (V1) and an orientation state analyser on the second channel (V1).

5. Vector magnetometer according to claim 4, wherein the alignment state analyser comprises a linear polariser (12) and a photodetector (13).

6. Vector magnetometer according to one of claims 4 or 5, wherein the circular orientation state analyser comprises a circular polariser (14, 15) and a photodetector (16).

7. Vector magnetometer according to claim 4, wherein the alignment state analyser comprises a quarter wave plate (19), a polarisation separator (17) that can separate the right circular polarisation and the left circular polarisation of the probe beam on a first and a second path, and a photodetector (18) on each of the first and second paths.

8. Vector magnetometer according to one of claims 4 to 7, wherein the orientation state analyser comprises a polarisation separator (20) that can separate horizontal linear polarisation and vertical linear polarisation of the probe beam on a first and a second path, and a photodetector (21) on each of the first and second paths.

9. Vector magnetometer according to one of claims 1 to 3, wherein the optical set up comprises a temporal separator of the probe beam that passed through the cell alternately into a circularly polarised beam and a linearly polarised beam, and an atomic state analyser (24, 25) downstream from the separator.

10. Vector magnetometer according to one of claims 1 to 9, wherein the polarisation device (3) is configured so as to simultaneously confer the linear polarisation and the circular polarisation on the pump beam emitted towards the cell.

11. Vector magnetometer according to one of claims 1 to 9, wherein the polarisation device (3) is configured so as to alternately confer the linear polarisation and then the circular polarisation on the pump beam emitted towards the cell.

12. Method of measuring a magnetic field using a vector magnetometer (10) comprising a cell (1) filled with an atomic gas subjected to an ambient magnetic field, an optical pumping source (2) capable of emitting a pump beam matched to a pumping wavelength towards the cell, a parametric resonance detection device (6) receiving a probe beam (L) that has passed through the cell, the probe beam being the pump beam or a beam distinct from the pump beam, and a closed loop slaving system (7, 8, 9) of the magnetometer to make it operate in zero field, **characterised in that** it includes steps consisting of linearly and circularly polarising the pump beam emitted towards the cell so as to place the atoms of the atomic gas in an aligned and oriented state, and to use an optical set up of the detection device to separate optical signals carrying information about an alignment state and information about an orientation state respectively, of atoms of the atomic gas, from the probe beam that passed through the cell.

FIG. 1

$$\vec{B}_{RF1} = \vec{z} \cdot B_1 \cos(\omega t)$$

$$\vec{B}_{RF3} = \vec{x} \cdot B_3 \cos(\xi t)$$

$$\vec{B}_0$$

$$\vec{B}_{RF2} = \vec{y} \cdot B_2 \cos(\Omega t)$$

$$\vec{k}$$

$$\vec{E} \parallel \vec{x}$$

FIG. 2

FIG. 3

FIG. 4

FIG. 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 5254947 A

- US 2008106261 A1

**Littérature non-brevet citée dans la description**

- **J. DUPONT-ROC.** Détermination par des méthodes optiques des trois composantes d'un champ magnétique très faible. *Revue de Physique Appliquée,* 1970, vol. 5 (6), 853-864
- **D. BUDKER et al.** Résonant nonlinear magneto-optical effects in atoms. *Rev. Mod. Phys.,* Novembre 2002, vol. 74 (4), 1153-1201

- **S. MORALES et al.** Magnetocardiography measurements with He vector optically pumped magnetometers at room temperature. *Phys. Med. Biol.,* 2017
- **F. LALOË ; M. LEDUC ; P. MINGUZZI.** Relations entre l'état angulaire d'une vapeur atomique soumise au pompage optique et ses propriétés d'absorption et de dispersion. *Journal de Physique,* 1969, vol. 30 (2-3), 277-288